(19) **Europäisches Patentamt / European Patent Office / Office européen des brevets**

(11) **EP 4 697 043 A1**

(12) **EUROPEAN PATENT APPLICATION**
published in accordance with Art. 153(4) EPC

(43) Date of publication:
18.02.2026 Bulletin 2026/08

(21) Application number: 24845875.4

(22) Date of filing: 10.07.2024

(51) International Patent Classification (IPC):
$G01R\ 31/392^{(2019.01)}$ $\qquad$ $G01R\ 31/382^{(2019.01)}$
$G01R\ 31/396^{(2019.01)}$ $\qquad$ $G01R\ 31/36^{(2020.01)}$
$H02J\ 7/00^{(2026.01)}$

(52) Cooperative Patent Classification (CPC):
G01R 31/367; G01R 31/3828; G01R 31/392;
G01R 31/396

(86) International application number:
PCT/KR2024/009824

(87) International publication number:
WO 2025/023572 (30.01.2025 Gazette 2025/05)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 25.07.2023 KR 20230097073
07.11.2023 KR 20230152643
08.07.2024 KR 20240089432

(71) Applicant: LG Energy Solution, Ltd.
Seoul 07335 (KR)

(72) Inventors:
• KIM, Young Min
Daejeon 34122 (KR)
• PARK, Jung Uk
Daejeon 34122 (KR)

(74) Representative: Plasseraud IP
104 Rue de Richelieu
CS92104
75080 Paris Cedex 02 (FR)

(54) **BATTERY DIAGNOSIS DEVICE AND OPERATION METHOD THEREOF**

(57) The technology is directed to diagnosing a battery by diagnosing an abnormality in a battery cell using state of health (SOH). The abnormality in a battery cell is diagnosed based on a deviation value obtained by calculating a difference between a SOH value of a target battery cell and an average value of SOH values of the plurality of battery cells in the battery.

FIG.1

**Description**

**[TECHNICAL FIELD]**

CROSS-REFERENCE TO RELATED APPLICATION

This application claims the priority of Korean Patent Application No. 10-2024-0089432 filed on July 8, 2024, Korean Patent Application No. 10-2023-0152643 filed on November 7, 2023, and Korean Patent Application No. 10-2023-0097073 filed on July 25, 2023, in the Korean Intellectual Property Office, the disclosures of which are incorporated herein by reference.

TECHNICAL FIELD

The embodiments described in this document are directed to an apparatus for diagnosing battery and operating method thereof.

**[BACKGROUND ART]**

Secondary batteries are batteries that can be charged and discharged. Example secondary batteries include Ni/Cd batteries, Ni/MH batteries, and lithium-ion batteries. Lithium-ion batteries have a higher energy density than that of the Ni/Cd batteries and Ni/MH batteries. In addition, lithium-ion batteries can be manufactured to be small and lightweight. Secondary batteries can be used in a variety of devices. For example, the secondary batteries can be used in mobile devices, such as mobile phones, laptop computers, smart phones, and/or smart pads, electricity-powered vehicles, such as electric vehicles (EVs), hybrid electric vehicles (HEVs), and/or plug-in hybrid electric vehicles (P-HEVs), and/or large-capacity power storage systems, such as energy storage systems.
These batteries can be implemented in a battery pack. The battery pack may include a battery module in which a plurality of battery cells are connected in series and/or parallel. Additionally, or alternatively, the batteries can be implemented in a battery rack. The battery rack may include a plurality of battery modules and a rack frame accommodating the battery modules. A battery management system (BMS) may manage the state and operation of the batteries. The BMS may be included together with the batteries within a single device or separate as its own device. For example, the BMS may be implemented as a separate server apparatus. The BMS may collect battery data and vehicle data from the vehicle, etc., and manage and control the batteries using the collected data.
If a battery is defective, the possibility of damage to the battery or any apparatuses the battery may be powering, such as EVs or ESSs may increase. For example, a type of defect in which the anode tab and/or the cathode tab of the battery cell are cut may lead to an instantaneous decrease in battery capacity or may cause an imbalance within the battery pack due to capacity deviation.

**[DISCLOSURE]**

**[TECHNICAL PROBLEM]**

Aspects of the disclosure are directed to diagnosing a battery by diagnosing an abnormality in a battery cell using state of health (SOH). The abnormality in a battery cell is diagnosed based on a deviation value obtained by calculating a difference between a SOH value of a target battery cell and an average value of SOH values of the plurality of battery cells in the battery.

**[TECHNICAL SOLUTION]**

An aspect of the disclosure provides for a method for diagnosing a battery including: acquiring, by one or more processors, time series data related to a state of each of a plurality of battery cells of the battery; calculating, by one or more processors, a state of health (SOH) of each of the plurality of battery cells based on the time series data; calculating, by one or more processors, a moving average value for each of the plurality of battery cells by applying a moving average filter to each of the calculated SOH; calculating, by one or more processors, a deviation value for a target battery cell of the plurality of battery cells based on a deviation between an average value of the plurality of calculated moving average values of the plurality of battery cells and the calculated moving average value of the target battery cell; and diagnosing, by one or more processors, an abnormality in the target battery cell based on the deviation value.
Another aspect of the disclosure provides for an apparatus including: one or more processors; and one or more memory coupled to the one or more processors and storing instructions that, when executed by the one or more processors, cause the one or more processors to perform operations for the method for diagnosing a battery. Yet another aspect of the disclosure provides for a non-transitory computer readable medium storing instructions that, when executed by one or more processors, cause the one or more processors to perform operations for the method for diagnosing a battery.

In an example, calculating the SOH further includes: calculating an SOC difference before and after a charging section for each of the plurality of battery cells based on the time series data; calculating a current integration value in the charging section for each of the plurality of battery cells based on the time series data; and calculating a SOHc for each of the plurality of battery cells based on the SOC difference, the current integration value, and an initial capacity of each of the plurality of battery cells. In another example, the current integration value is calculated if the SOC difference is equal to or greater than a designated value. In yet another example, calculating the SOHc is based on:

$$SOH_c = \frac{I \Delta T}{\frac{\Delta SOC}{100} \times C} \times 100$$

where I∆T is the current integration value, ∆SOC is the SOC difference, and C is the initial capacity.

In yet another example, the moving average filter includes an exponential moving average (EMA) filter. In yet another example, the EMA filter calculates an EMA value based on: $EMA_t = \alpha \times SOH + (1-\alpha) \times EMA_{t-1}$ where EMAt is an EMA value in a current cycle of the battery cell, $\alpha$ is a weight, SOH is the SOH in the current cycle of the battery cell, and EMAt-1 is the EMA value in a previous cycle.

In yet another example, diagnosing an abnormality in the target battery cell further includes diagnosing the target battery cell as a defective battery cell if the deviation value is equal to or greater than a threshold value.

In yet another example, the method further includes performing an abnormality processing function based on an abnormality diagnosis of the target battery cell. In yet another example, the abnormality processing function comprises at least one of a notification function, a short-circuit function, or isolating the target battery cell.

**[ADVANTAGEOUS EFFECTS]**

According to the aspects of the disclosure, an accuracy of diagnosing the abnormality in the battery related to capacity reduction or capacity deviation can be improved.

**[DESCRIPTION OF DRAWINGS]**

The above and other aspects, features and other advantages of the present invention will be more clearly understood from the following detailed description taken in conjunction with the accompanying drawings, in which:

FIG. 1 depicts a block diagram of an apparatus for diagnosing a battery according to aspects of the disclosure;
FIG. 2 depicts a graph illustrating SOHc of a plurality of battery cells calculated by the apparatus for diagnosing the battery according to aspects of the disclosure;
FIG. 3 depicts a graph illustrating exponential moving average (EMA) values of a plurality of battery cells calculated by the apparatus for diagnosing the battery according to aspects of the disclosure; and
FIG. 4 is an operation flowchart of the apparatus for diagnosing the battery according to an embodiment.

**[MODE FOR INVENTION]**

The technology generally relates to diagnosing an abnormality in a battery cell of a battery using SOH. The abnormality is diagnosed based on a deviation value obtained by calculating a deviation between a moving average SOH value of a target battery cell and an average value of moving average SOH values of the plurality of battery cells in the battery.

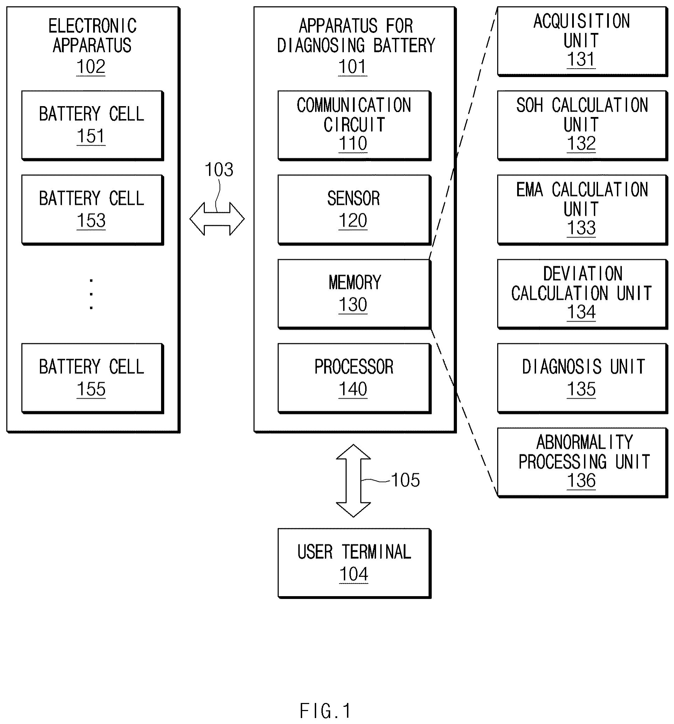

FIG. 1 is a block diagram of an apparatus 101 for diagnosing a battery. The apparatus 101 for diagnosing a battery may be implemented as a battery management system (BMS) within an electronic apparatus 102, and/or may be implemented as a BMS within one or more external apparatuses, such as servers, clouds, and/or chargers/dischargers. As examples, the electronic apparatus 102 may be a mobile device, such as a mobile phone, laptop computer, smart phone, and/or smart pad, an electricity-powered vehicles, such as an electric vehicle (EV), hybrid EV (HEV), plug-in HEV (PHEV), and/or fuel cell EV (FCEV), an energy storage system (ESS), and/or a battery swapping system (BSS).

The apparatus 101 for diagnosing the battery may be connected to the electronic apparatus 102 and a user terminal 104 in a wired manner and/or wirelessly. The connection 103 between the apparatus 101 for diagnosing the battery and the electronic apparatus 102 and/or the connection 105 between the apparatus 101 for diagnosing the battery and the user terminal 104 may be a communication connection through a wired and/or wireless network. As an example, the wired network may be based on a local area network (LAN) communication or a power line communication. As another example, the wireless network may be based on a short-distance communication network, such as Bluetooth, wireless fidelity (WiFi), or infrared data association (IrDA)), or a long-distance communication network, such as a cellular network, 4G network, or 5G network. The connection 103 between the apparatus 101 for diagnosing the battery and the electronic apparatus 102 and/or the connection 105 between the apparatus 101 for diagnosing the battery and the user terminal 104 may be a connection through an apparatus-to-apparatus communication method, such as a bus, general purpose input and output (GPIO), serial peripheral interface (SPI), and/or mobile industry processor interface (MIPI).

The electronic apparatus 102 may include a plurality of battery cells 151, 153, and 155. Here, each of the battery cells 151, 153, and 155 may be a single battery cell, or may also be a cell group in which at least two or more battery cells are connected in parallel. The electronic apparatus 102 may include at least one battery module and/or at least one battery pack including the plurality of battery cells 151, 153, and 155. For example, the plurality of battery cells 151, 153, and 155 may be included in one battery module or one battery pack.

As examples, the user terminal 104 may be a mobile device, such as a mobile phone, a laptop computer, a smart phone, and/or a smart pad, or a personal computer (PC). The apparatus 101 for diagnosing the battery may provide information related to a diagnosis result of the battery cells 151, 153, or 155 to the user terminal 104.

The apparatus 101 for diagnosing the battery may include a communication circuit 110, a sensor 120, a memory 130, and a processor 140. The communication circuit 110 may establish a wired communication channel and/or a wireless communication channel between the apparatus 101 for diagnosing the battery and the electronic apparatus 102 and/or the user terminal 104. The communication circuit 110 may transmit and receive data to and from the electronic apparatus 102 and/or the user terminal 104 through the established communication channel.

The sensor 120 may measure information related to states of the plurality of battery cells 151, 153, and 155 of the electronic apparatus 102. The states may include voltage, current, resistance, state of charge (SOC), state of health (SOH), and/or temperature, as examples. For example, when the apparatus 101 for diagnosing the battery is implemented as the BMS within an electronic apparatus, the apparatus 101 for diagnosing the battery may directly measure state values of the plurality of battery cells 151, 153, and 155 using the sensor 120.

The communication circuit 110 and/or the sensor 120 may acquire time series data related to the states of the plurality of battery cells 151, 153, and 155. The time series data may refer to data representing the voltage, current, resistance, SOC, SOH, and/or temperature of the plurality of battery cells 151, 153, and 155 over time.

The memory 130 may include a volatile memory and/or a nonvolatile memory. The memory 130 may be a non-transitory computer readable medium that stores instructions that are executed by the processor 140. The memory 130 may store data used by at least one component, such as the processor 140, of the apparatus 101 for diagnosing the battery. For example, the data may include software, instructions, input data, and/or output data. When executed by the processor 140, the instructions may cause the apparatus 101 for diagnosing a battery abnormality to perform operations defined by the instructions.

The processor 140 may control at least one other component of the apparatus 101 for diagnosing the battery connected to the processor 140 by executing software stored in the memory 130 and/or performing various data processing or calculations. As examples, the processor 140 may include a central processing unit, an application processor, a graphics processing unit, a neural processing unit (NPU), an image signal processor, a sensor hub processor, and/or a communication processor.

The memory 140 may include one or more software modules, including an acquisition unit 131, a SOH calculation unit 132, an exponential moving average (EMA) calculation unit 133, a deviation calculation unit 134, a diagnosis unit 135, and an abnormality processing unit 136 for diagnosing abnormalities in the plurality of battery cells 151, 153, and 155.

The acquisition unit 131 may acquire time series data related to the states of the plurality of battery cells 151, 153, and 155. The acquisition unit 131 may acquire the time series data using the communication circuit 110 and/or the sensor 120.

The SOH calculation unit 132 may calculate the SOH of the plurality of battery cells 151, 153, and 155 based on the time series data acquired by the acquisition unit 131. The SOH refers to a parameter related to a lifespan of the battery cells 151, 153, and/or 155. The SOH may include SOHc, which indicates the SOH associated with the capacity of the battery, and/or SOHr, which indicates the SOH associated with the resistance growth of the battery.

The SOH calculation unit 132 may calculate a SOC difference before and after a charging section of the plurality of battery cells 151, 153, and 155 based on the time series data. For example, the SOH calculation unit 132 may calculate the SOC difference using a SOC value at a first time point before or at the beginning of the charging section and the SOC value at a second time point after or at the end of the charging section based on SOC data included in the time series data. As another example, the SOH calculation unit 132 may calculate an open circuit voltage (OCV) of the plurality of battery cells 151, 153, and 155 based on time series voltage data and/or time series current data included in the time series data. The SOH calculation unit 132 may calculate the SOC difference after converting the calculated OCV into the SOC using an SOC-OCV table previously stored in the memory 130.

The SOH calculation unit 132 may calculate a current integration value in the charging section of the plurality of battery cells 151, 153, and 155 based on the time series data. For example, the SOH calculation unit 132 may calculate the current integration value in the charging section based on a current value of the charging section and a time length of the charging section included in the time series data. Here, the unit of the current integration value may be an 'ampere hour (Ah)', as an example.

According to another embodiment, the SOH calculation unit 132 may calculate the current integration value in the charging section if the calculated SOC difference is equal to or greater than a designated value.

The SOH calculation unit 132 may calculate the SOHc for each of the battery cells 151, 153, and/or 155 based on the SOC difference, the current integration value, and an initial capacity of each of the battery cells 151, 153, and/or 155. Here, the unit of the initial capacity of the battery cells 151, 153, and/or 155 may be 'Ah', as an example, which may be the same as the unit of the current integration value.

For example, the SOH calculation unit 132 may calculate the SOHc of the battery cells 151, 153, and/or 155 based on Equation 1.

[Equation 1]

$$SOH_c = \frac{I\Delta T}{\frac{\Delta SOC}{100} \times C} \times 100$$

In Equation 1, $I\Delta T$ is the current integration value of each of the battery cells 151, 153, and/or 155, $\Delta SOC$ is the SOC difference of each of the battery cells 151, 153, and/or 155, and C is the initial capacity of each of the battery cells 151, 153, and/or 155.

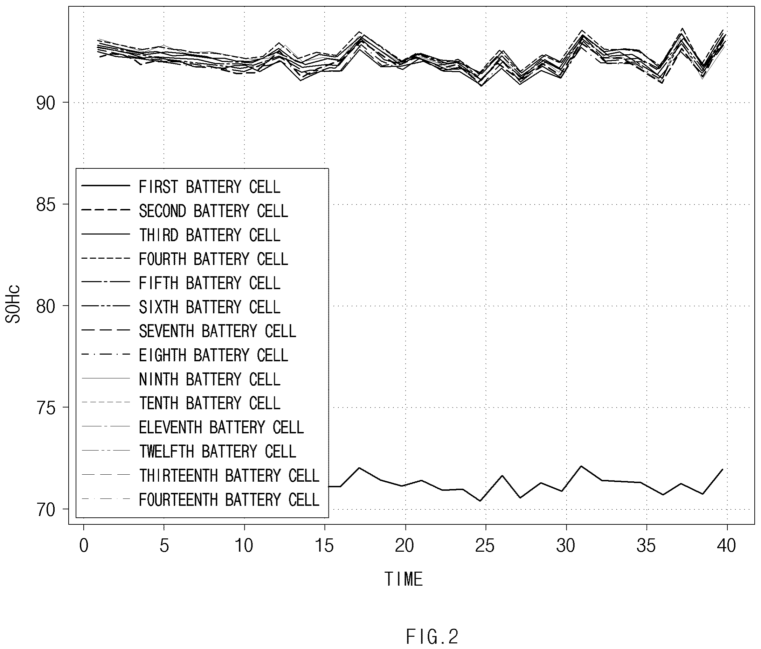

FIG. 2 is an example graph 200 illustrating the SOHc of a plurality of battery cells calculated by the apparatus 101 for diagnosing the battery. In the graph 200, the X-axis may represent time and the Y-axis may represent SOHc. The SOH calculation unit 132 may calculate the SOHc of battery cells to be diagnosed at every designated cycle. The apparatus 101 for diagnosing the battery may manage SOHc data, such as the graph 200, by cumulatively storing the SOHc calculated by the SOH calculation unit 132 in the memory 130 for a designated time.

Referring back to FIG. 1, the moving average calculation unit 133 may calculate a moving average value by applying a moving average filter to one or more of the SOH calculated by the SOH calculation unit 132. For example, the moving average calculation unit 133 may calculate the moving average value of a target battery cell 151, 153, or 155 by applying the moving average filter to the SOH of the target battery cell 151, 153, or 155 calculated by the SOH calculation unit 132. The moving average filter may include a simple moving average (SMA) filter, a weighted moving average (WMA) filter, and/or an exponential moving average (EMA) filter.

For example, the EMA filter may calculate the EMA value in the current cycle by inputting the EMA value in the previous cycle and the SOH in the current cycle of the battery cell 151, 153, or 155 into Equation 2.

[Equation 2]

$$EMA_t = \alpha \times SOH + (1-\alpha) \times EMA_{t-1}$$

In Equation 2, $EMA_t$ is the EMA deviation value in the current cycle of the battery cell 151, 153, or 155, $\alpha$ is the weight, SOH is the SOH in the current cycle of the battery cell 151, 153, or 155, and $EMA_{t-1}$ is the EMA deviation value in the previous cycle of the battery cell 151, 153, or 155. Here, the weight may be set in various ways depending on specifications of the plurality of battery cells 151, 153, and 155. For example, the weight may be set to 0.05, but is not limited thereto.

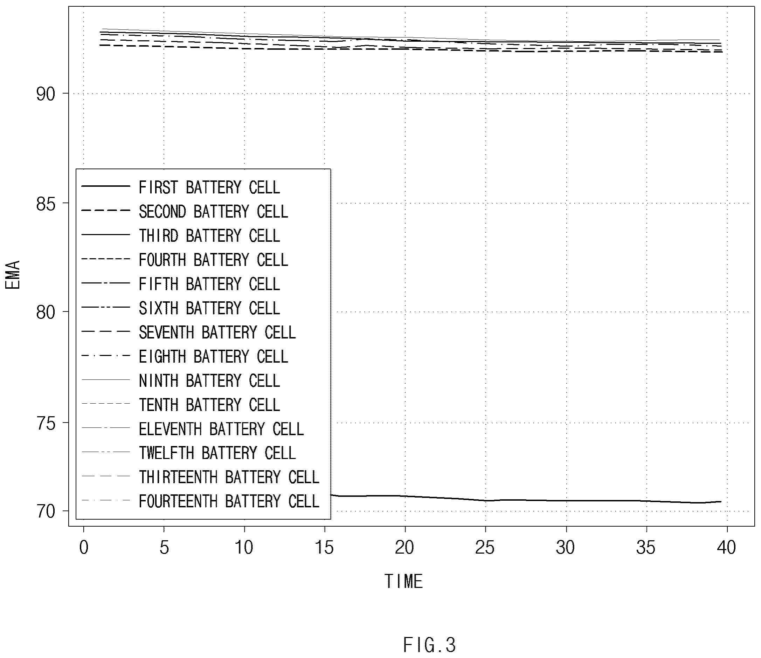

FIG. 3 is an example graph 300 illustrating EMA values of the plurality of battery cells calculated by the apparatus 101 for diagnosing the battery based on the moving average calculation unit 133 over time. In the graph 300, the X-axis may represent time and the Y-axis may represent EMA values. The moving average calculation unit 133 may calculate the moving average value of the battery cells to be diagnosed at every designated cycle. The apparatus 101 for diagnosing the battery may manage moving average data, such as the graph 300, by cumulatively storing the moving average value calculated by the moving average calculation unit 133 in the memory 130 for a designated time. For example, the moving average calculation unit 133 may acquire the moving average data of battery cells to be diagnosed by applying the SOH data, such as the graph 200 in FIG. 2 stored in the memory 130, to the moving average filter.

Referring back to FIG. 1, the deviation calculation unit 134 may calculate a deviation value between the average value of a plurality of moving average values of the plurality of battery cells 151, 153, and 155 and the moving average value of the target battery cell 151, 153, or 155. For example, the deviation value may be a difference between the moving average value of a target battery cell 151, 153, or 155 and the average value of the moving average values of the plurality of battery cells 151, 153, and 155 of the battery.

The diagnosis unit 135 may diagnose an abnormality in the target battery cell 151, 153, or 155 based on the deviation value calculated by the deviation calculation unit 134. For example, the diagnosis unit 135 may diagnose whether or not the target battery cell 151, 153, or 155 is defective due to a decrease in capacity. The diagnosis unit 135 may diagnose whether there is an abnormality in the target battery cell 151, 153, or 155 by comparing the deviation value with a threshold value previously stored in the memory 130. For example, if the deviation value of the target battery cell 151, 153, or 155 is equal to or greater than the threshold value, the diagnosis unit 135 may diagnose the target battery cell 151, 153, or 155 as an abnormal battery cell. If the deviation value of the target battery cell 151, 153, or 155 is less than the threshold value, the diagnosis unit 135 may diagnose the target battery cell 151, 153, or 155 as a normal battery cell. The diagnosis unit 135 may diagnose an abnormality in each of the plurality of battery cells 151, 153, and 155 based on respective deviation values for each of the plurality of battery cells 151, 153, and 155.

The abnormality processing unit 136 may perform an abnormality processing function based on any abnormality diagnoses from the diagnosis unit 135. Abnormality processing functions may include a notification function or a short-circuit function, as examples. Abnormality processing functions may also include isolating any abnormal battery cells from the electronic apparatus 102. Isolation may include electrical and/or mechanical isolation, as examples. The abnormality processing unit 136 may transmit any abnormality diagnosis of the plurality of battery cells 151, 153, and 155 to the user terminal 104 connected through a wired and/or wireless network.

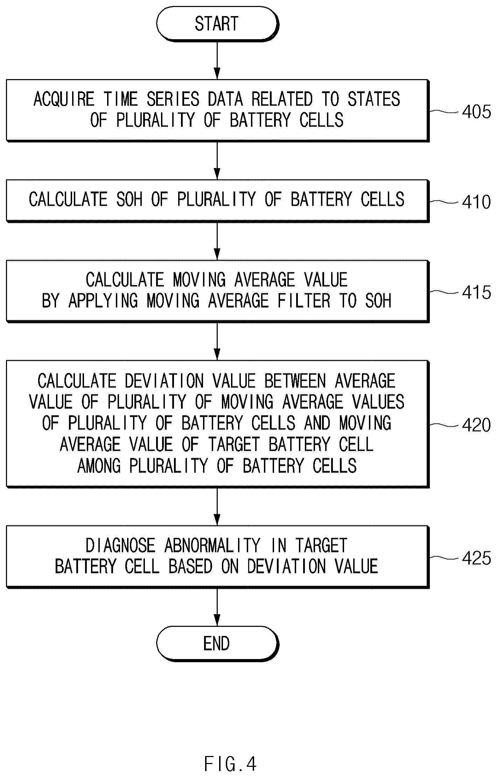

FIG. 4 is an example operation flowchart of the apparatus for diagnosing the battery. FIG. 4 may be implemented using the configurations of FIG. 1.

In the example operation depicted in FIG. 4, the order of steps may be different from that illustrated in FIG. 4, some of the steps illustrated in FIG. 4 may be omitted, the order between the steps may be changed, and/or the steps may be merged.

Referring to FIG. 4, in operation 405, the apparatus 101 for diagnosing the battery acquires time series data related to the states of the plurality of battery cells 151, 153, and 155. For example, the apparatus 101 for diagnosing the battery may acquire the time series data using the communication circuit 110 and/or the sensor 120.

In operation 410, the apparatus 101 for diagnosing the battery calculates the SOH of each of the plurality of battery cells 151, 153, and/or 155 based on the time series data acquired in operation 405. The apparatus 101 for diagnosing the battery may calculate the SOC difference before and after the charging section of each of the plurality of battery cells 151, 153, and/or 155 based on the time series data. The apparatus 101 for diagnosing the battery may calculate the current integration value in the charging section of each of the plurality of battery cells 151, 153, and/or 155 based on the time series data. Here, the unit of the current integration value may be the 'ampere hour (Ah)', as an example.

According to another embodiment, the apparatus 101 for diagnosing the battery may calculate the current integration value in the charging section if the calculated SOC difference is equal to or greater than a designated value.

The apparatus 101 for diagnosing the battery may calculate the SOHc based on the SOC difference, the current integration value, and an initial capacity of each of the plurality of battery cells 151, 153, and/or 155. Here, the unit of the initial capacity of the battery cells 151, 153, and/or 155 may be 'Ah', which is the same as the unit of the current integration value, as an example. For example, the apparatus 101 for diagnosing the battery may calculate the SOHc of each of the battery cells 151, 153, and/or 155 based on Equation 1 described above.

In operation 415, the apparatus 101 for diagnosing the battery calculates the moving average value by applying the moving average filter to the SOH calculated for each of the plurality of battery cells 151, 153, and/or 155. The moving average filter may include the simple moving average (SMA) filter, the weighted moving average (WMA) filter, and/or the exponential moving average (EMA) filter. For example, the EMA filter may calculate the EMA value in the current cycle by inputting the EMA value in the previous cycle and the SOH in the current cycle of each of the battery cells 151, 153, and/or 155 into Equation 2 described above.

In operation 420, the apparatus 101 for diagnosing the battery calculates the deviation value between the average value of a plurality of moving average values of the plurality of battery cells 151, 153, and 155 and the moving average value of a target battery cell 151, 153, or 155. For example, the deviation value may be a difference between the moving average value of a target battery cell 151, 153, or 155 and the average value of the moving average values of the plurality of battery cells 151, 153, and 155 of the battery.

In operation 425, the apparatus 101 for diagnosing the battery diagnoses an abnormality in the target battery cell 151, 153, or 155 based on the deviation value. For example, the apparatus 101 for diagnosing the battery may diagnose whether or not the target battery cell 151, 153, or 155 is defective due to a decrease in capacity. The apparatus 101 for diagnosing the battery may diagnose the abnormality in the target battery cell 151, 153, or 155 by comparing the deviation value with a threshold value. For example, if the deviation value of the target battery cell 151, 153, or 155 is equal to or greater than the threshold value, the apparatus 101 for diagnosing the battery may diagnose the target battery cell 151, 153, or 155 as an abnormal battery cell. The apparatus 101 for diagnosing the battery may diagnose an abnormality in each of the plurality of battery cells 151, 153, and 155 based on respective deviation values for each of the plurality of battery cells 151, 153, and 155.

Unless otherwise stated, the foregoing examples are not mutually exclusive, but may be implemented in various combinations to achieve unique advantages. As these and other variations and combinations of the features discussed above can be utilized without departing from the subject matter defined by the claims, the foregoing description of aspects of the disclosure should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible examples. Further, the same reference numbers in different drawings can identify the same or similar elements.

The singular form of a noun corresponding to an item may include one or more of the items unless the relevant context clearly indicates otherwise. In this document, each of phrases such as "A or B," "at least one of A and B," "at least one of A or B," "A, B, or C," "at least one of A, B, and C," and" at least one of A, B, or C" may include any one of the items listed together in that phrase of the phrases, or any possible combination thereof. Terms such as "first", "second", "firstly", "secondly", "A", "B", "(a)", or "(b)" may be used simply to distinguish such a component from other such components and, unless specifically stated to the contrary, do not limit such elements in any other respect (e.g., importance or order).

**Claims**

1. An apparatus for diagnosing a battery comprising:

   one or more processors; and
   one or more memory coupled to the one or more processors and storing instructions that, when executed by the one or more processors, cause the one or more processors to perform operations for diagnosing a battery, the operations comprising:

   acquiring time series data related to a state of each of a plurality of battery cells of the battery;
   calculating a state of health (SOH) of each of the plurality of battery cells based on the time series data;
   calculating a moving average value for each of the plurality of battery cells of the battery by applying a moving average filter to each of the calculated SOH;
   calculating a deviation value for a target battery cell of the plurality of battery cells based on a deviation between an average value of the plurality of calculated moving average values of the plurality of battery cells and the calculated moving average value of the target battery cell; and
   diagnosing an abnormality in the target battery cell based on the deviation value.

2. The apparatus for diagnosing a battery of claim 1, wherein calculating the SOH further comprises:

   calculating an SOC difference before and after a charging section for each of the plurality of battery cells based on the time series data;
   calculating a current integration value in the charging section for each of the plurality of battery cells based on the time series data; and
   calculating a SOHc for each of the plurality of battery cells based on the SOC difference, the current integration value, and an initial capacity of each of the plurality of battery cells.

3. The apparatus for diagnosing a battery of claim 2, wherein the current integration value is calculated if the SOC difference is equal to or greater than a designated value.

4. The apparatus for diagnosing a battery of claim 2, wherein calculating the SOHc is based on:

$$SOH_c = \frac{I \Delta T}{\frac{\Delta SOC}{100} \times C} \times 100$$

wherein IΔT is the current integration value, ΔSOC is the SOC difference, and C is the initial capacity.

5. The apparatus for diagnosing a battery of claim 1, wherein the moving average filter comprises an exponential moving average (EMA) filter.

6. The apparatus for diagnosing a battery of claim 5, wherein the EMA filter calculates an EMA value based on:

$$EMA_t = \alpha \times SOH + (1-\alpha) \times EMA_{t-1}$$

wherein EMAt is an EMA value in a current cycle of the battery cell, $\alpha$ is a weight, SOH is the SOH in the current cycle of the battery cell, and EMAt-1 is the EMA value in a previous cycle.

7. The apparatus for diagnosing a battery of claim 1, wherein diagnosing an abnormality in the target battery cell further comprises diagnosing the target battery cell as a defective battery cell if the deviation value is equal to or greater than a threshold value.

8. The apparatus for diagnosing a battery of claim 1, wherein the operations further comprise performing an abnormality processing function based on an abnormality diagnosis of the target battery cell.

9. The apparatus for diagnosing a battery of claim 8, wherein the abnormality processing function comprises at least one of a notification function, a short-circuit function, or isolating the target battery cell.

10. A method for diagnosing a battery comprising:

acquiring, by one or more processors, time series data related to a state of each of a plurality of battery cells of the battery;
calculating, by the one or more processors, a state of health SOH of each of the plurality of battery cells based on the time series data;
calculating, by the one or more processors, a moving average value for each of the plurality of battery cells of the battery by applying a moving average filter to each of the calculated SOH;
calculating, by the one or more processors, a deviation value for a target battery cell of the plurality of battery cells based on a deviation between an average value of the plurality of calculated moving average values of the plurality of battery cells and the calculated moving average value of the target battery cell; and
diagnosing, by the one or more processors, an abnormality in the target battery cell based on the deviation value.

11. The method of claim 10, wherein calculating the SOH further comprises:

calculating an SOC difference before and after a charging section for each of the plurality of battery cells based on the time series data;
calculating a current integration value in the charging section for each of the plurality of battery cells based on the time series data; and
calculating a SOHc for each of the plurality of battery cells based on the SOC difference, the current integration value, and an initial capacity of each of the plurality of battery cells.

12. The method of claim 11, wherein the current integration value is calculated if the SOC difference is equal to or greater than a designated value.

13. The method of claim 11, wherein calculating the SOHc is based on:

$$SOH_c = \frac{I \Delta T}{\frac{\Delta SOC}{100} \times C} \times 100$$

wherein IΔT is the current integration value, ΔSOC is the SOC difference, and C is the initial capacity.

14. The method of claim 10, wherein the moving average filter comprises an exponential moving average (EMA) filter.

15. The method of claim 14, wherein the EMA filter calculates an EMA value based on:

$$EMA_t = \alpha \times SOH + (1-\alpha) \times EMA_{t-1}$$

wherein EMAt is an EMA value in a current cycle of the battery cell, $\alpha$ is a weight, SOH is the SOH in the current cycle of the battery cell, and EMAt-1 is the EMA value in a previous cycle.

16. The method of claim 10, wherein diagnosing an abnormality in the target battery cell further comprises diagnosing the target battery cell as a defective battery cell if the deviation value is equal to or greater than a threshold value.

17. The method of claim 10, further comprising performing, by the one or more processors, an abnormality processing function based on an abnormality diagnosis of the target battery cell.

18. The method of claim 17, wherein the abnormality processing function comprises at least one of a notification function, a short-circuit function, or isolating the target battery cell.

19. A non-transitory computer readable medium storing instructions that, when executed by one or more processors, cause the one or more processors to perform operations for diagnosing a battery, the operations comprising:

    acquiring, by one or more processors, time series data related to a state of each of a plurality of battery cells of the battery;
    calculating, by the one or more processors, a state of health SOH of each of the plurality of battery cells based on the time series data;
    calculating, by the one or more processors, a moving average value for each of the plurality of battery cells of the battery by applying a moving average filter to each of the calculated SOH;
    calculating, by the one or more processors, a deviation value for a target battery cell of the plurality of battery cells based on a deviation between an average value of the plurality of calculated moving average values of the plurality of battery cells and the calculated moving average value of the target battery cell; and
    diagnosing, by the one or more processors, an abnormality in the target battery cell based on the deviation value.

20. The non-transitory computer readable medium of claim 19, wherein calculating the SOH further comprises:

    calculating an SOC difference before and after a charging section for each of the plurality of battery cells based on the time series data;
    calculating a current integration value in the charging section for each of the plurality of battery cells based on the time series data; and
    calculating a SOHc for each of the plurality of battery cells based on the SOC difference, the current integration value, and an initial capacity of each of the plurality of battery cells.

FIG.1

FIG.2

FIG.3

EP 4 697 043 A1

START

ACQUIRE TIME SERIES DATA RELATED TO STATES
OF PLURALITY OF BATTERY CELLS ~ 405

CALCULATE SOH OF PLURALITY OF BATTERY CELLS ~ 410

CALCULATE MOVING AVERAGE VALUE
BY APPLYING MOVING AVERAGE FILTER TO SOH ~ 415

CALCULATE DEVIATION VALUE BETWEEN AVERAGE
VALUE OF PLURALITY OF MOVING AVERAGE VALUES
OF PLURALITY OF BATTERY CELLS AND MOVING
AVERAGE VALUE OF TARGET BATTERY CELL
AMONG PLURALITY OF BATTERY CELLS ~ 420

DIAGNOSE ABNORMALITY IN TARGET
BATTERY CELL BASED ON DEVIATION VALUE ~ 425

END

FIG.4

## INTERNATIONAL SEARCH REPORT

| International application No. |
|---|
| **PCT/KR2024/009824** |

| A. | CLASSIFICATION OF SUBJECT MATTER |
|---|---|

**G01R 31/392**(2019.01)i; **G01R 31/382**(2019.01)i; **G01R 31/396**(2019.01)i; **G01R 31/36**(2006.01)i; **H02J 7/00**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); B60L 3/00(2006.01); B60L 58/16(2019.01); G01R 19/00(2006.01); G01R 31/36(2006.01); H01M 10/42(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), SOH(state of health), 이동 평균(moving average), 편차(deviation), SOC(state of charge)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2020-0109092 A (SAMSUNG SDI CO., LTD.) 22 September 2020 (2020-09-22)<br>See paragraphs [0038]-[0184]; claims 1-20; and figures 1-8. | 1-20 |
| A | KR 10-2022-0074797 A (LG ENERGY SOLUTION, LTD.) 03 June 2022 (2022-06-03)<br>See paragraphs [0044]-[0213]; claims 1-20; and figures 1-7. | 1-20 |
| A | KR 10-2017-0083308 A (LG CHEM, LTD.) 18 July 2017 (2017-07-18)<br>See paragraphs [0029]-[0048]; claims 1-9; and figures 1-4. | 1-20 |
| A | JP 2020-119712 A (TOSHIBA CORPORATION et al.) 06 August 2020 (2020-08-06)<br>See paragraphs [0009]-[0125]; claims 1-11; and figures 1-20. | 1-20 |
| A | WO 2016-158396 A1 (HITACHI AUTOMOTIVE SYSTEMS, LTD.) 06 October 2016 (2016-10-06)<br>See paragraphs [0012]-[0099]; claims 1-11; and figures 1-26. | 1-20 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **23 October 2024** | **23 October 2024** |

| Name and mailing address of the ISA/KR | Authorized officer |
|---|---|
| **Korean Intellectual Property Office**<br>**Government Complex-Daejeon Building 4, 189 Cheongsa-**<br>**ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/009824**

| Patent document cited in search report | | | Publication date (day/month/year) | Patent family member(s) | | | Publication date (day/month/year) |
|---|---|---|---|---|---|---|---|
| KR | 10-2020-0109092 | A | 22 September 2020 | CN | 113557439 | A | 26 October 2021 |
| | | | | EP | 3940405 | A1 | 19 January 2022 |
| | | | | EP | 3940405 | A4 | 21 December 2022 |
| | | | | EP | 3940405 | B1 | 11 September 2024 |
| | | | | JP | 2022-524827 | A | 10 May 2022 |
| | | | | JP | 7292404 | B2 | 16 June 2023 |
| | | | | KR | 10-2629463 | B1 | 25 January 2024 |
| | | | | US | 12050251 | B2 | 30 July 2024 |
| | | | | US | 2022-0082626 | A1 | 17 March 2022 |
| | | | | WO | 2020-184812 | A1 | 17 September 2020 |
| KR | 10-2022-0074797 | A | 03 June 2022 | CN | 115461634 | A | 09 December 2022 |
| | | | | EP | 4152021 | A1 | 22 March 2023 |
| | | | | EP | 4152021 | A4 | 03 January 2024 |
| | | | | JP | 2023-519949 | A | 15 May 2023 |
| | | | | JP | 2024-099795 | A | 25 July 2024 |
| | | | | JP | 7483922 | B2 | 15 May 2024 |
| | | | | KR | 10-2024-0109971 | A | 12 July 2024 |
| | | | | KR | 10-2684286 | B1 | 11 July 2024 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2017-0083308 | A | 18 July 2017 | KR | 10-1980150 | B1 | 20 May 2019 |
| JP | 2020-119712 | A | 06 August 2020 | JP | 7265364 | B2 | 26 April 2023 |
| | | | | US | 11300625 | B2 | 12 April 2022 |
| | | | | US | 2020-0233037 | A1 | 23 July 2020 |
| WO | 2016-158396 | A1 | 06 October 2016 | CN | 107533109 | A | 02 January 2018 |
| | | | | CN | 107533109 | B | 04 September 2020 |
| | | | | EP | 3279679 | A1 | 07 February 2018 |
| | | | | EP | 3279679 | A4 | 31 October 2018 |
| | | | | EP | 3279679 | B1 | 29 June 2022 |
| | | | | JP | 6496810 | B2 | 10 April 2019 |
| | | | | US | 11124072 | B2 | 21 September 2021 |
| | | | | US | 2018-0074129 | A1 | 15 March 2018 |

Form PCT/ISA/210 (patent family annex) (July 2022)

15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240089432
- KR 1020230152643

- KR 1020230097073